# EUROPEAN PATENT SPECIFICATION

(11) **EP 2 686 735 B1**
(45) Date of publication and mention of the grant of the patent: **06.01.2016**
(21) Application number: 12706905.2
(22) Date of filing: 27.02.2012
(51) Int. Cl.: G03F 7/095, G03F 7/16, G06F 3/041

(54) **PHOTOPATTERNABLE STRUCTURE CONTAINING SUBSTRATE WITH TWO-SIDE PHOTORESIST COATINGS**
FOTOSTRUKTURIERBARE STRUKTUR MIT BEIDESEITIGEN ENTHALTENDEN FOTOSCHICHT SUBSTRAT
STRUCTURE REALISABLE PAR PHOTOEXPOSITION CONTENANT UN SUBSTRAT AVEC UNE COUCHE PHOTORESISTE SUR LES DEUX FACES

(30) Priority: 18.03.2011 GB 201104581
(43) Date of publication of application: 22.01.2014
(73) Proprietor: CIT Technology Limited, Ossett, Yorkshire WF5 9WS (GB)
(72) Inventor: BENTLEY, Philip Gareth, Cambridge, Cambridgeshire CB24 4QG (GB); THOMAS, David Stephen, Cambridge, Cambridgeshire CB4 3LN (GB)
(74) Representative: Matthews, Heather Clare
(86) International application number: PCT/GB2012/050439
(87) International publication number: WO 2012/127205

(56) References cited:
- US-A- 4 548 884
- US-A- 5 532 105
- US-A1- 2008 158 181
- DATABASE WPI Week 201119 Thomson Scientific, London, GB; AN 2011-C41855 XP002676062, -& TW 201 007 363 A (WANG J) 16 February 2010 (2010-02-16) & TW 201 007 363 B (WANG WEN [TW]; WANG JEN [TW]) 16 February 2010 (2010-02-16)

## Description

### Field of the invention

This invention relates to photopatterning of materials, e.g. by the process of photolithography, and concerns a photopatternable structure with photosensitive material and a method of patterning such a structure, with the invention finding application in the production of patterned materials for use in the fields of electronics, optics or related disciplines.

### Background of the Invention

Photolithography has been widely used for patterning structures in the fields of electronics and microelectronics. Printed circuit boards for the electronics industry and silicon integrated circuits have been produced by the process of photolithography for many decades. In the process of photolithography, a photosensitive material is selectively exposed in pattern wise manner to electromagnetic radiation (usually ultraviolet (UV), visible, infra red or a combination thereof) of a wavelength which causes a physical or chemical change in the material such that it can be used to form a pattern. Typically, the exposure causes the material to become more or less soluble, effectively changing the state of the material from soluble to insoluble (or vice versa) with respect to a particular solvent or developing medium. The solvent or developing medium can then be used to remove either the exposed or unexposed regions of the photosensitive material. Commonly, such materials will be referred to as photoresists. Once exposed to the patterning radiation and then developed, the resulting patterned resist can be used as a barrier to protect certain areas of the underlying material from chemical or physical attack from a range of wet or dry etching species. For example, a photoresist may be coated on top of a copper clad epoxy glass board, for producing printed circuits. Regions of this photoresist which are exposed to UV light can become soluble in a particular developer solution. Once exposed and developed, the copper metal will be exposed only in areas which were previously exposed to UV light. If the board is now immersed in a solution of ferric chloride, the exposed regions of copper will be dissolved away, leaving the regions which are still coated in resist. Subsequent removal of the resist will leave the desired pattern of copper on the board. Typically this would be in the pattern of a series of tracks and pads onto which electronics devices may be mounted and connected to each other.

The process of photolithography is also used to pattern devices on transparent substrates. This is particularly common in the field of information display and human machine interface. In liquid crystal display devices, patterns of data may be displayed by etching shapes into a layer of Indium Tin Oxide (ITO), which is an optically transparent conducting material, which coats the two layers of glass which make up the display cell. Layers of ITO may also be patterned to form the electrodes for projected capacitive touch screens, input devices which allow the user to interact directly with the image displayed on the screen.

Photoresist materials are typically used for a subtractive patterning process, i.e. those where unwanted material is removed and the required material is protected by the resist, but photolithography may also be used for additive processes.

In the field of printed circuit boards, it is commonplace to produce multilayered structures. To do this, it is common to clad both faces of an epoxy-glass board with copper foil, coat both in a photoresist material. It is economically and technically advantageous to pattern both sides of the board at the same time, e.g. by simultaneous exposure to UV light, to reduce the number and complexity of process steps. Since the copper foil is opaque, there are no problems of through-cure with light from the top surface exposing photoresist on the bottom surface and vice versa, so this approach works well for such printed circuit boards.

In applications such as displays, touch screens, solar cells and lighting it would be desirable to be able to perform simultaneous two sided photolithography on the optically transparent substrate materials such as ITO-coated glass or plastic that are used in these fields. Unfortunately, this is usually impossible because the transparent nature of the substrate means that if one side of the material is exposed to light then the other side is also exposed through the transparent substrate material, i.e. through-cure takes place. This means that when dual-sided photolithography is attempted on transparent materials, interference occurs between the two sides and instead of producing a unique pattern on each side, both sides are similarly patterned with the sum of the two patterns on each side.

Consequently, such devices will often either be made up of several substrates with only one patterned layer on each substrate, or may be patterned by two or more repeated resist application, exposure and developing stages. This may work for resists which are rendered insoluble by exposure to light but the technique cannot be used with resists which are rendered soluble as the second exposure stage will still expose the already patterned resist on the first side of the material.

The present invention aims to address the problem of enabling photopatterning to be performed on both sides of an optically transparent substrate.

US 2008/158181 discloses sequential patterning and hardening of photoresists on opposite sides of a soda-lime glass or similar substrate.

US 4548884 discribes registration of a photomask with optically opaque substrates such as copper clad substrate and aluminium plate.

US 5532105 concerns a photolithographic technique for producing viaholes for fabrication of multilayer wiring boards.

TW 201007363 describes photolithographic patterning of two-sided coatings.

### Summary of the Invention

In one aspect, the present invention provides a photopatternable structure, comprising an optically transparent substrate having first and second faces, a coating of a photosensitive material on each of the first and second faces, the coated substrate being opaque to electromagnetic radiation of one or more wavelengths to which the photosensitive material is sensitive.

The term "optically transparent" is used to mean that the substrate is capable of transmitting all or part of the visible spectrum of electromagnetic radiation (typically in the range of 380 nm to 720 nm). Radiation transmission levels may be quite low, e.g. as low as transmission of 1% of incident radiation, yet provided it is still possible to see through the substrate with the human eye, this is still considered to be optically transparent. Further, many display devices produce the illusion of the full spectrum of colour by combining various proportions of light in the primary colours, red, green and blue. In such systems, the shortest wavelength component may only extend down to around 420 nm and in this case window materials need not transmit light of shorter wavelength than this in order to appear colourless.

The substrate is typically planar, being e.g. in the form of a board, sheet or film, with the first and second faces opposed to each other.

The substrate may be made of a wide range of materials, that may be optically transparent over a wide range of wavelengths or over a narrow band or bands of wavelengths. Suitable substrates include, e.g., polyethylene terephthalate (PET), polycarbonate, polyethylene-naphthalate (PEN) e.g. PEN films known by the Trade Mark Teonex available from Teijin Du Pont Films. For instance Teonex Q65 PEN film has a transmission of only 2% or less for wavelengths shorter than 375 nm, i.e. it absorbs UV light. The substrate may also comprise polarising material.

The term "photosensitive material" is used to mean a material which gives rise to a chemical or physical change in a curing reaction when exposed to electromagnetic radiation of one or more particular wavelengths, e.g. from a specific region of the electromagnetic spectrum. Such radiation is referred to as radiation to which the photosensitive material is sensitive to produce a curing reaction. The resulting radiation-induced change may be due to the generation of reactive chemical species via absorption of radiation (e.g. the generation of free radicals leading to polymerisation or the fission of chemical bonds in a polymer leading to increased solubility). This radiation-induced change may alternatively be a radiation induced physical change (e.g. an optically induced change of conformation in a polymer chain leading to increased free volume and a resulting expansion of the material). The radiation-induced change (or curing reaction) typically results in a change of solubility, as discussed above. In general, this change will occur at a rate which is related to the rate of absorption of photons of light of the relevant wavelengths.

Photosensitive materials are well known, and a wide range of suitable photosensitive materials are readily available and known to those skilled in the art. The wavelength range over which photosensitive materials are active can be controlled by the choice of the chemical species which are used to activate the photochemical reactions used to alter their state. Typically, the material will include one or more chromaphores (i.e. a species which absorbs electromagnetic radiation) which become chemically reactive in their optically excited states.

The photosensitive material may be a negative acting material (e.g. it is rendered insoluble by the action of curing radiation and is therefore developed to form the negative image of the opaque regions of a photomask). Alternatively, the photosensitive material may be a positive acting material (e.g. it is solubilised by exposure to curing radiation and therefore forms a copy of the opaque regions of a photomask).

The photosensitive material coatings are typically in the form of a layer that may cover in uninterrupted manner all or a substantial portion of the substrate face.

A coating of a first photosensitive material is provided on the first face of the substrate, and a coating of a second photosensitive material is provided on the second face of the substrate. Typically, the same photosensitive material is used on each of the first and second faces, i.e. the first photosensitive material is the same as the second photosensitive material, but this is not essential, and different photosensitive materials may be used on each face, with the first photosensitive material being different from the second photosensitive material.

The term "opaque" is used in relation to the substrate to mean that the coated substrate has limited transmission to electromagnetic radiation of the one or more wavelengths to which the first and second photosensitive materials are sensitive. It is not necessary that transmission of such radiation is prevented completely (0% transmission), but preferably transmission is less than about 50%, more preferably less than about 10% and ideally less than about 2%. The substrate may itself be opaque, as required. Alternatively, the substrate combined with a coating of the photosensitive material may have the necessary opacity. For instance, the substrate may transmit 50% of the relevant radiation, but if the first photosensitive material on the first face also only transmits 50% of the radiation, then only 25% of the radiation will pass to be the second photosensitive material on the second face. In an extreme example the substrate may transmit 95% of the relevant radiation, but the transmitted radiation may be reduced to, say, 10% by the effect of the first photosensitive material on the first face. By providing suitably tailored or engineered combinations of substrate and photosensitive materials, opaque coated substrates may be produced.

The term substrate is used to refer to the material between the photosensitive coatings and may be made up of several layers. For example: the substrate may comprise a core substrate material with one or more coatings on one or both sides to modify its surface properties (e.g. adhesion, surface tension, chemical resistance); the substrate may comprise a core substrate material with one or more layers/coatings on one or both sides in order to modify its optical transmission; and the substrate may comprise core substrate material with an optically transparent functional layer on one or both sides which is later to be modified using the patterned photosensitive coating as a template.

A surface coating, such as a protective layer, may optionally be provided on one or both of the photosensitive material coatings. This is typically in the form of an inert coating.

In use, the first and/or second faces of the structure are exposed (sequentially or simultaneously) to radiation to which the photosensitive materials are sensitive and to which the coated substrate is opaque, which is referred to as curing radiation. The photosensitive material is exposed under suitable conditions (e.g. radiation intensity, exposure time etc.) so that the photosensitive material undergoes a radiation-induced curing reaction, as discussed above, typically resulting in a change of solubility.

In a further aspect, the present invention provides a method of photopatterning a photopatternable structure in accordance with the invention, comprising exposing the first and second photosensitive materials to curing radiation to which the photosensitive materials are sensitive but to which the coated substrate is opaque.

It will thus be apparent that by selection of suitable substrate, photosensitive materials and curing radiation, so through-cure can be avoided, enabling two sided photopatterning.

The faces of the structure are typically exposed to radiation in patternwise manner, to produce photopatterning, with the patterns on the two faces typically being different. Selective exposure of the faces to curing radiation to produce photopatterning may be performed in a number of ways, as is well known in the art, including: by exposure through a mask or aperture which is imaged onto the photosensitive material or which is in contact with or in close proximity to the material; by exposing the photosensitive material to a small area of radiation which is then moved or scanned to form a desired pattern, e.g. by direct writing with a laser beam or by the movement of an aperture plate; or by causing the radiation to form an intereference pattern by being diffracted onto the material, e.g. by a grating or slit, or by the projection of a hologram.

The patterns of radiation exposure on the photosensitive materials on the first and second faces are typically different.

Because the substrate is opaque to the curing radiation, no through-cure occurs, so that two different patterns may be produced by the curing reaction of the photosensitive material on the first and second faces. Thus, the photopatternable structure of the invention may be used for two sided photopatterning in a way not hitherto possible.

After the curing reaction, the photosensitive material may be processed in conventional manner, typically being subjected to a developing process using a developing medium, typically one or more solvents, selectively to remove soluble photosensitive material from the substrate, leaving behind patterns of insoluble photosensitive material on the first and second faces of the substrate, typically different patterns on the two faces.

In embodiments having a surface coating, this is preferably soluble in the developing medium; if not, the surface coating should be removed prior to the developing step. e.g. by treatment with a suitable solvent.

The resulting patterned photosensitive material (on one or both faces) may play many roles. For example, it may form an etch mask which protects the underlying material from a wet or dry etch process; it may form a template which prevents subsequent material from being deposited on the underlying material (e.g. by evaporation of metals or electroplating); and it may form a template on which a subsequent layer is formed (e.g. it may be a catalyst for electroless plating or a reactive layer onto which chemical or biological species may bind).

Use of a structure in accordance with the invention enables photopatterning to be performed on both faces of the substrate either simultaneously, or before the first face has been developed.

The curing radiation must be selected having regard to the properties of the substrate and the photosensitive materials.

Where there is no overlap in the wavelengths at which the substrate is not opaque and the wavelengths of radiation to which the photosensitive materials are sensitive, it is possible to use curing radiation of any wavelength provided it includes one or more wavelengths to which the photosensitive materials are sensitive. In particular, it is possible to use a broad band source of radiation. Suitable broad band sources are well known, with convenient sources including a mercury arc lamp which emits radiation at wavelengths from 260 nm and longer. For instance, in one embodiment a photosensitive material which is sensitive to radiation in the region between 200 nm and 365 nm is as the first and second photosensitive material and is coated onto both faces of a Teonex Q65 PEN film substrate from DuPont Teijin Films. This material has a transmission of only 2% or less for wavelengths shorter than 375 nm. The material is exposed in patternwise manner, e.g. by use of a mask, to broad band illumination from a mercury arc lamp, which emits radiation at wavelengths from 260 nm and longer. Although the radiation above 375 nm will be strongly transmitted by the substrate, the photosensitive material does not absorb at these long wavelengths and is therefore not exposed on the remote side of the substrate, i.e. the overlap function of the system is close to zero in the region of transmission of the film, so there is no through-cure.

In one approach, the invention uses photosensitive materials based on chromaphores which absorb light of a shorter wavelength than may be transmitted by the substrate.

In contrast, in cases where there is overlap in the wavelengths at which the substrate is not opaque and the wavelengths of radiation to which the photosensitive materials are sensitive, then a suitably selective radiation source must be used. For instance, it may be appropriate to use a radiation source that has a very narrow emission spectrum such as a laser, a light emitting diode (LED) or a filtered atomic emission lamp such as a mercury I-line source which emits radiation in a narrow band around 365 nm. Such radiation sources may be used, e.g, in conjunction with a photosensitive material that has a relatively broad sensitivity spectrum. For example, in one embodiment, a photosensitive material which is sensitive to radiation from 200 nm to 450 nm is used as the first and second photosensitive material and is coated onto both sides of a Teonex Q65 PEN film substrate. The top face of the film is exposed in patterwise manner, e.g. by use of a mask, to radiation from a frequency tripled Nd:YAG laser at 355 nm. Although the substrate material is transmissive in regions where the photosensitive material absorbs light, the exposure source emits light only in a very narrow wavelength band which is strongly absorbed by the substrate material. This means that the overlap function of the system is zero in the region of transmission of the film and the bottom layer of photosensitive material is not exposed, so there is no through-cure.

Where the substrate comprises polarising material (linear or circular), then by using appropriate polarised light it is possible to prevent transmission of light through the substrate and so avoid through-cure. In a particular embodiment, where the radiation source emits polarised light (or is filtered to do so) the substrate material need only have reduced transmission for that polarisation of light throughout the region where there is overlap in the wavelengths at which the substrate is not opaque and the wavelengths of radiation to which the photosensitive material is sensitive. For example, if the radiation source were polarised North-South then the substrate material need only block transmission to this polarisation and could be fully transmitting to radiation polarised in the East-West direction. This could be achieved by using a sheet of polarising material as the substrate. A further example uses a combination of a quarter-wave plate and a linear polariser, which would block/transmit one or the other of clockwise or anticlockwise circularly polarised light. Such an arrangement would have particular use in a display device such as a liquid crystal display and, for example, might allow a touch screen functionality to be combined with the polariser functionality in a display in order to reduce the total number of layers and hence device thickness and weight.

Broad band radiation sources are typically cheaper than narrow band radiation sources. Curing times may need to be determined having regard to the intensity of the radiation source, and in particular with narrow band sources it may be necessary to use a higher intensity.

The rate of reaction of the photosensitive materials may be linear or non linear. For example, the rate of generation of reactive species (or the rate of physical change) may be super-linear with respect to the intensity of incident radiation (e.g. the rate of reaction may be proportional to the square of the incident intensity). Further, the photosensitive materials may saturate such that above a certain incident intensity the rate of reaction may no longer increase.

The effectiveness of the system may also depend on the intensity of the radiation source and the duration of the exposure. For instance, exposing the system to a higher intensity of radiation for a shorter time may lead to a higher contrast between exposed and unexposed faces than exposure to a lower intensity for longer times. This will be especially true for super linear systems (e.g. systems where the rate of reaction goes as the square of the incident intensity). This will also be true of systems where extrinsic effects can inhibit the reaction at lower intensities (e.g. oxygen inhibition in free radical base UV curing resins).

The photochemical reaction undergone by the photosensitive materials must proceed to a sufficient extent in order to prevent the material from being removed during subsequent reaction, such as a development process. This does not necessarily require 100% reaction. For example, a UV-induced cross-linking reaction might need to proceed to only 20% of full reaction in order to gel the resin and render if insoluble in developing medium. In this case, a system in which the substrate permitted limited transmission of radiation to which the photosensitive materials are sensitive might nevertheless be acceptable provided reaction conditions, particularly exposure times, were such that insufficient reaction took place in the photosensitive material on the side of the substrate remote from the radiation source to alter the solubility properties of the photosensitive material.

In a further aspect, the invention provides a photopatternable structure in accordance with the invention together with instructions for use. The instructions should specify appropriate curing radiation, e.g. in terms of wavelength, whether the light should be polarised and if so the orientation etc. Suitable radiation intensities may also be given. Suitable curing times are also desirably specified.

The invention may also be considered and analysed in terms of the spectral overlap function (SOF) of the photosensitive materials and curing radiation. To do this, various terms need to be defined.

The "absorption spectrum" of a photosensitive material is the fraction of incident electromagnetic radiation absorbed by the material over a range of wavelengths.

The "sensitivity spectrum" of a photosensitive material is similar to the absorption spectrum of the photosensitive material, but is defined as a plot of the rate of generation of the desired chemically reactive species versus wavelength for the photochemical species.

The "region of sensitivity of the photosensitive material" is the region of the electromagnetic spectrum over which absorption of radiation in the photosensitive material results in generation of the reactive species which lead to the desired change in the material (e.g. cross linking or being rendered soluble). This is the region of the electromagnetic spectrum where the sensitivity spectrum shows a finite rate of generation, or where the rate of generation is greater than about 1% of the maximum.

It should be noted that the sensitivity spectrum and the region of sensitivity of the photosensitive material are not the same as the absorption spectrum, because the absorption spectrum may include features which are due to optical transitions which do not give rise to the generation of the desired chemically reactive species. For example, a photoreactive material which has been doped with a blue dye would have an absorption feature in the red or infra-red which would be due to the dye and would not generate reactive species.

The "emission spectrum" of the radiation source is the emission spectrum (mWcm²nm⁻¹) of the radiation source which is used to expose the photosensitive material in the photo patterning process.

The "spectral overlap function" (SOF) of a particular system comprising a structure in accordance with the invention for use with a particular radiation source is defined as the product of the sensitivity spectrum of the photosensitive material and the emission spectrum of the radiation source (obtained by multiplying together the values at each wavelength of the sensitivity spectrum and the spectrum of the radiation source).

The substrate must be selected having regard to the SOF of the system.

The most important wavelengths of radiation in the photochemical patterning reaction are those where the spectral overlap function is finite, i.e. where the value of neither the sensitivity spectrum or the emission spectrum is zero. In practice, it is appropriate to consider regions where the SOF is greater than 10% of its peak value. This is because although the reaction of photosensitive material can still proceed on exposure to radiation wavelengths where the SOF is between 0 and 10% of its peak, in this region the reaction will be very slow in comparison to the regions where it is higher.

The invention thus provides a system for performing photopatterning on photosensitive material on first and second faces of an optically transparent substrate, with the system comprising a radiation source with given spectrum; photosensitive material with given spectrum of sensitivity; and a substrate material with given transmission spectrum.

The components of the system are selected such that the substrate material has limited transmission of electromagnetic radiation in the region of the spectrum where the spectral overlap function is greater than about 10% of its maximum value. It may be beneficial to adopt a regime where the SOF is greater than this theoretical minimum and preferably the system is such that the SOF is greater than about 50% of its maximum value, possibly greater that about 80% of its maximum value.

The spectral overlap function will in general have a narrower spectrum than the sum of the emission spectrum of the radiation source and the spectrum of sensitivity of the photosensitive material. A broad band exposure source (e.g. a high pressure mercury lamp) may be used in conjunction with a photosensitive material which only absorbs radiation between 200 nm and 320 nm. A photosensitive material which has a relatively broad sensitivity spectrum may be used in conjunction with an exposure source which has a very narrow emission spectrum, e.g. a laser, a LED or a filtered atomic emission lamp such as a mercury I-line source.

The invention also covers a patterned structure produced from a photopatternable structure in accordance with the invention or by use of the method of the invention. The resulting structure typically has different patterns on the first and second faces.

The resulting structure may be subjected to further processing steps. For example, the patterned material may be used as a mask for the etching of the underlying material or as a template for the growth of material on the underlying substrate or upon itself.

The exposure of the photosensitive material may also give rise to a physical change such as swelling (which may be used in stamping), charging or discharging (e.g. laser printer) or a colour change (photography).

The invention finds particular application in the manufacture of items useful in the fields of electronics, optics and related disciplines, particularly items with transmissive layers involved in information display, such as visual displays and touch screens, particularly capacitative touch screens.

The invention will be further described, by way of illustration, in the following Examples and with reference to the accompanying drawings.

In the drawings;
Figure 1 is a schematic diagram illustrating a photopatternable structure in accordance with the invention, prior to patterning;
Figure 2 is a view similar to Figure 1 of the structure after patterning;
Figure 3 is a pair of graphs with Figure 3a showing the sensitivity spectrum of a particular photosensitive material (shown in an unbroken line and labelled 'rate') and the emission spectrum of a particular radiation source (shown in dashed lines and labelled 'intensity') and Figure 3b showing the spectral overlap function (SOF) of the photosensitive material and radiation source;
Figure 4 is a pair of graphs similar to Figure 3 for a different photosensitive material and radiation source; and
Figure 5 is a further pair of graph similar to Figure 3 for a different photosensitive material and radiation source.

### Detailed description of the drawings

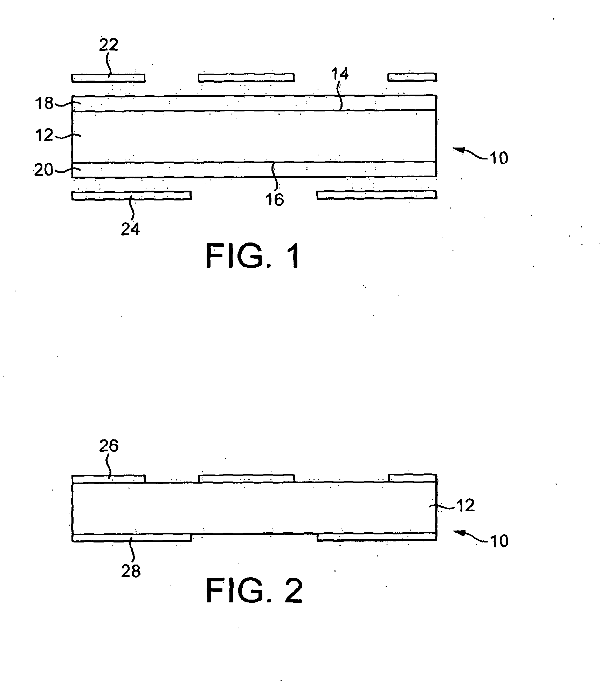

Referring to the drawings, Figure 1 show schematically (and not to scale) a photopatternable structure 10 in accordance with the invention, comprising a sheet of optically transparent substrate material 12 having opposed first and second faces 14, 16. Each face bears a coating 18, 20 of the same photosensitive material.

In use, the faces of the structure are exposed in patterwise manner to curing radiation from a source (not shown) by the use of respective masks 22, 24. The two faces are conveniently exposed simultaneously. The two masks have different patterns. The curing radiation is selected having regard to the properties of the substrate and photosensitive material, as explained above. Exposure to curing radiation under appropriate conditions, e.g. time, results in reaction of only the exposed parts of the photosensitive layers 18, 20 not covered by the masks, without through-cure occurring, and alters the solubility properties of the photosensitive material with respect to a particular developing medium. In the illustrated embodiment, a positive acting photosensitive material is used that is converted from insoluble to soluble condition on exposure to curing radiation. Treatment with the developing medium under appropriate conditions results in selective removal of photosensitive material only in the reacted exposed regions, leaving photocurable material on the substrate only on those areas corresponding to the mask, in patterns 26 and 28 as shown in Figure 2. Because no through-cure occurs, it is possible to produce different patterns on the opposed faces of the substrate.

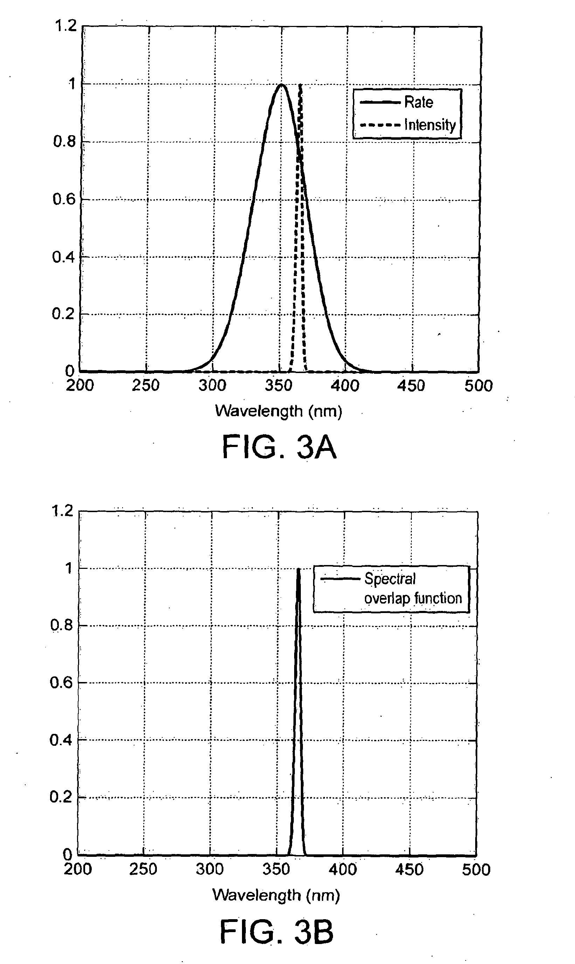

Figure 3 illustrates the sensitivity spectrum of a photosensitive material with a relatively broad range of sensitivity, from about 280 nm to 420 nm, and the emission spectrum of a relatively narrow band radiation source centred on about 365 nm, e.g. a mercury I-line source, and the resulting spectral overlap function.

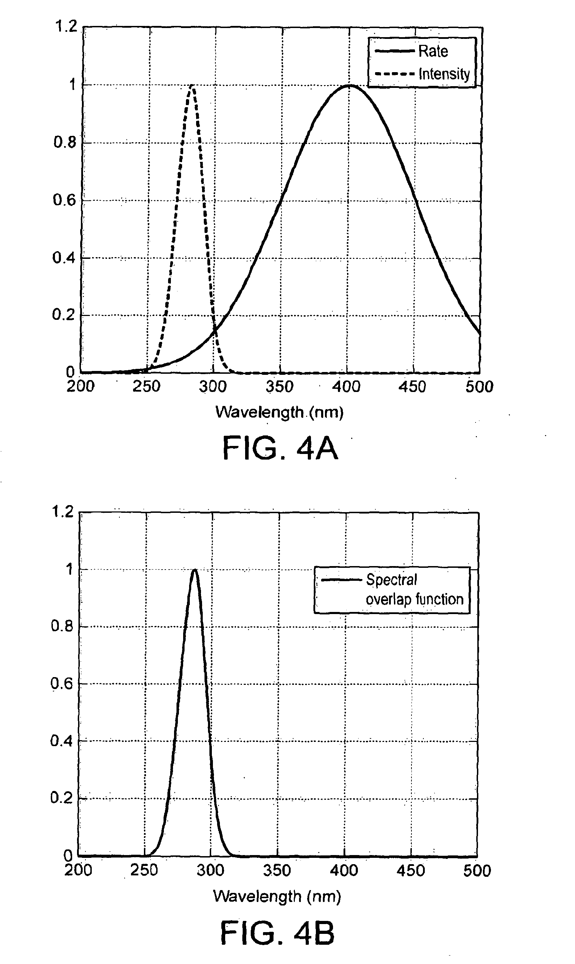

Figure 4 is similar to Figure 3 but for a photosensitive material with a relatively narrow range of sensitivity, from about 250 nm to 320 nm coupled with a broader band radiation source such as a light emitting diode.

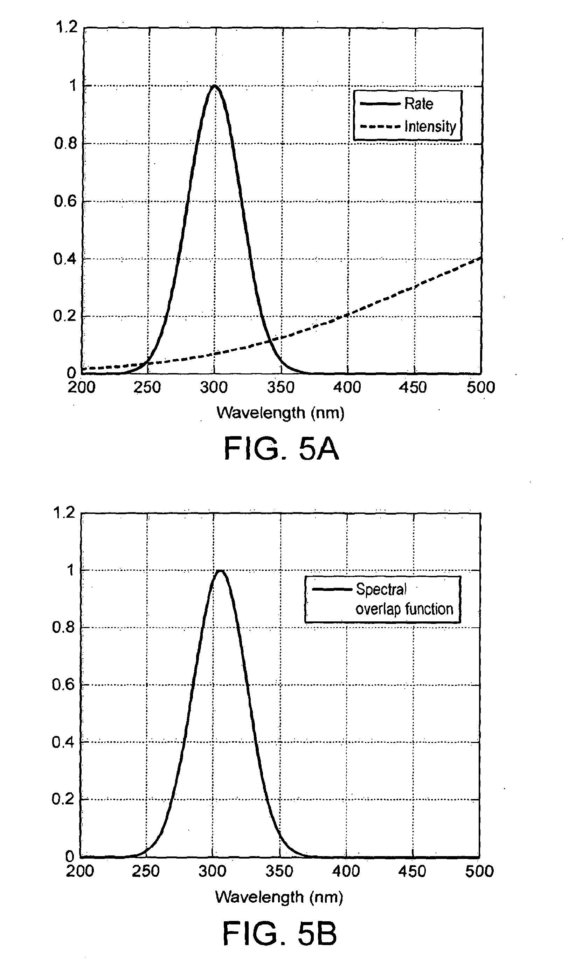

Figure 5 is similar to Figure 3 for a photosensitive material with a relatively narrow range of sensitivity, from about 240 nm to 360 nm, used with the high energy tail of a broad band radiation source such as a tungsten halogen lamp.

In all of the above cases, an optically transparent substrate which transmits the whole visible spectrum but which absorbs UV light, e.g. polyethylene naphthalate, could be used as a substrate of a structure in accordance with the invention without through-cure occurring.

### Examples

### Example 1

To demonstrate the effect of the spectral transmission of the substrate material, samples were prepared on two different substrate films.

### Substrates:

1. PET - PMX726, 50µ HiFi Films
2. PEN - Teonex Q65FA, 100 µ DuPont Teijin Films

PET has strong optical transmission (above 10%) down to 315 nm. PEN on the other hand, absorbs strongly below 375 nm.

In these experiments, Irgacure 907 (Irgacure is a Trade Mark) is employed as a photoinitiator material. Irgacure 907 has its peak absorption between 300 nm and 320 nm. Above 340 nm this absorption drops off to well below 10% of its peak value.

### Coatings:

All coatings were applied by a 12µ drawdown bar and then dried on a hot plate at 50°C for 5 minutes.

A 3 layer process was used:
1. A base layer was first coated onto both sides of each substrate and then cured using a 1 kW mercury lamp. This was to ensure a compatible surface energy for the subsequent coatings.
2. An active layer of photosensitive material was then coated on top of the base layers and dried.
3. An inert top coat was then applied on top of the active layers. This dried to give a clear, non-tacky surface coating film which reduces oxygen inhibition during curing and protects the photomask from any damage from cure-on contamination from the active layer. The top coat is carefully formulated to be soluble in the developing medium to be used (DMSO/acetone) in the preset case (DMSO is dimethyl sulphoxide), while being capable of being applied from a solvent (water in this case) which does not attack the underlying photosensitive material coating.

The three formulations were as follows:
1st layer (base layer)

| | **Wt**.% |
|---|---|
| Ethyl lactate | 92.3 |
| DPHA | 7 |
| Irgacure 907 | 0.7 |

Viscosity = 2.96 cPs (25°C)
Dry thickness = 0.92µ
DPHA is a dipentaerythritol hexacrylate, a UV-curable hexafunctional monomer.
2nd layer (active layer) is the same as 1st layer, but is simply dried, and not cured.
3rd layer (top coat layer)

| | **Wt.%** | |
|---|---|---|
| Deionised water | 72.12 | |
| Mowiol 4-88 (TM) | 6.12 | Polyvinyl alcohol |
| Eastek 1100 (TM) | 18.39 | Polyester dispersion |
| Hydrocer EC35 (TM) | 2.21 | Wax emulsion |
| Dowfax 2A1 (TM) | 0.36 | Surfactant |
| Surfadone LP 100 (TM) | 0.50 | Surfactant |
| Novec FC4430 (TM) | 0.30 | Fluorosurfactant |

Dry thickness = 1.69 µ

The substrates were then sandwiched between two differently patterned chrome-on-glass photomasks and exposed to UV light using a 1 kW mercury lamp, for 5 seconds at 20mW/cm² on each side.

After exposure the samples were developed.

### Developing:

This was carried out using DMSO/acetone (50/50). The samples were immersed for 5 minutes in DMSO/acetone, rinsed with acetone from wash bottle, rinsed with deionised (DI) water from wash bottle, and blown dry with an air gun. This developing step selectively removes unexposed regions of the active layer. As noted above, the top coat is soluble in DMSO/acetone and so is removed in this step; if not it would be necessary to remove the top coat prior to developing, e.g. by treatment with a suitable solvent.

### Results:

The samples on the PEN substrate developed to show different patterns on each side of the film with no evidence of the through-cure. However, the samples on the PET substrate showed strong ghost images of the image on the opposite side of the film. This was due to transmitted light causing through-cure.

### Example 2

The photosensitive material in Example 1 may be turned into a catalyst for additive electroless plating by the addition of a catalytic material such as colloidal palladium.

### Plating:

A polyvinyl pyrrolidone (PVP)-based colloid was added to the photosensitive formulation described in Example 1 and processed using the same procedure. Exposure time was increased to 10 seconds to ensure thorough curing of the material. Developing was performed as in Example 1. During the DMSO/acetone stage, most of the unexposed catalyst material could be seen washing off to reveal the patterns from the photomasks. Copper plating was carried out in an Enthone Entrace EC 5005 bath at standard conditions. It was found that plating initiation could be more rapid if a dimethyl aminoborane (DMAB) pre-dip was used (1.6% solution at room temperature for 2 minutes) before plating. In either case, samples were plated for 3-4 minutes to give a continuous and lustrous copper film.

Photosensitive Catalyst formulation:

| | **Wt.%** |
|---|---|
| Ethyl lactate | 72.3 |
| DPHA | 7 |
| Irgacure 907 | 0.7 |
| Pd/PVP K15 colloid | 20 |

Formulation of Pd/PVP K15 colloid:

| | **Wt.%** |
|---|---|
| Ethyl lactate | 91 |
| Palladium acetate | 4.5 |
| PVP K15 | 4.5 |

## Claims

1. A photopatternable structure, comprising an optically transparent substrate having first and second faces, a coating of a first photosensitive material of the substrate on the first face and a coating of a second photosensitive material on the second face of the substrate, the coated substrate being opaque to electromagnetic radiation of one or more wavelengths to which the first and second photosensitive materials are sensitive.

2. A structure according to claim 1, wherein the first and second photosensitive materials are the same.

3. A structure according to claim 1 or 2, further comprising a surface coating on one or both of the coatings of photosensitive material.

4. A structure according to claim 3, wherein the surface coating is soluble in developing medium suitable for use in removing the photosensitive material, after curing.

5. A method of photopatterning a photopatternable structure in accordance with any one of the preceding claims, comprising exposing the first and second photosensitive materials to curing radiation to which the photosensitive materials are sensitive but to which the coated substrate is opaque.

6. A method according to claim 5, wherein the first and second faces of the structure are exposed to curing radiation simultaneously.

7. A method according to claim 5 or 6, wherein the faces of the structure are exposed to radiation in patternwise manner, to produce photopatterning.

8. A method according to claim 7, wherein the patterns on the two faces are different.

9. A method according to any one of claims 5 to 8, wherein after the curing reaction, the photosensitive materials are subjected to a developing process using a developing medium selectively to remove soluble photosensitive materials from the substrate, leaving behind patterns of insoluble photosensitive materials on the first and second faces of the substrate.

10. A method according to claim 9, wherein the developing medium also removes any surface coatings on the structure.

11. A method according to any one of the claims 5 to 10, wherein there is no overlap in the wavelengths at which the substrate is not opaque and the wavelengths of radiation to which the photosensitive materials are sensitive, and the structure is exposed to curing radiation from a broad band source of radiation.

12. A method according to any one of claims 5 to 10, wherein where there is overlap in the wavelengths at which the substrate is not opaque and the wavelengths of radiation to which the photosensitive materials are sensitive, and the structure is exposed to curing radiation from a narrow emission spectrum radiation source.

13. A patterned structure produced from a photopatternable structure in accordance with any one of claims 1 to 4.

14. A patterned structure according to claim 13, having different patterns on the first and second faces.

15. A touch screen, particularly a capacitative touch screen, comprising a patterned structure in accordance with claim 13 or 14.

## Patentansprüche

1. Fotostrukturierbare Struktur, umfassend ein optisch transparentes Substrat mit einer ersten und zweiten Seite, einer Beschichtung aus einem ersten lichtempfindlichen Material auf der ersten Seite des Substrats und einer Beschichtung aus einem zweiten lichtempfindlichen Material auf der zweiten Seite des Substrats, wobei das beschichtete Substrat opak für elektromagnetische Strahlung einer oder mehrerer Wellenlängen ist, für die das erste und zweite lichtempfindliche Material empfindlich sind.

2. Struktur gemäß Anspruch 1, wobei das erste und das zweite lichtempfindliche Material dasselbe sind.

3. Struktur gemäß Anspruch 1 oder 2, ferner umfassend eine Oberflächenbeschichtung auf einer oder beiden der Beschichtungen aus lichtempfindlichem Material.

4. Struktur gemäß Anspruch 3, wobei die Oberflächenbeschichtung in einem Entwicklungsmedium lösbar ist, das geeignet ist zur Verwendung beim Entfernen des lichtempfindlichen Materials nach Aushärten.

5. Verfahren zum Fotostrukturieren einer fotostrukturierbaren Struktur gemäß einem der vorhergehenden Ansprüche, umfassend Belichten des ersten und zweiten lichtempfindlichen Materials mit aushärtender Strahlung, für welche die lichtempfindlichen Materialien empfindlich sind, aber für welche das beschichtete Substrat opak ist.

6. Verfahren gemäß Anspruch 5, wobei die erste und zweite Seite der Struktur gleichzeitig mit aushärtender Strahlung belichtet werden.

7. Verfahren gemäß Anspruch 5 oder 6, wobei die Seiten der Struktur in einer strukturierten Weise mit Strahlung belichtet werden, um Fotostrukturierung herzustellen.

8. Verfahren gemäß Anspruch 7, wobei die Strukturierungen auf den beiden Seiten verschieden sind.

9. Verfahren gemäß einem der Ansprüche 5 bis 8, wobei nach der Aushärtungsreaktion die lichtempfindlichen Materialien einem Entwicklungsprozess ausgesetzt werden, unter selektivem Verwenden eines Entwicklungsmediums, um lösbare lichtempfindliche Materialien von dem Substrat zu entfernen, wobei Strukturen nichtlösbarer lichtempfindlicher Materialien auf der ersten und zweiten Seite des Substrats zurückbleiben.

10. Verfahren gemäß Anspruch 9, wobei das Entwicklungsmedium auch jegliche Oberflächenbeschichtungen auf der Struktur entfernt.

11. Verfahren gemäß einem der Ansprüche 5 bis 10, wobei es keine Überschneidung gibt zwischen den Wellenlängen, für welche das Substrat nicht opak ist, und den Wellenlängen von Strahlung, für welche die lichtempfindlichen Materialien empfindlich sind, und wobei die Struktur mit aushärtender Strahlung von einer breitbandigen Strahlungsquelle belichtet wird.

12. Verfahren gemäß einem der Ansprüche 5 bis 10, wobei es eine Überschneidung gibt zwischen den Wellenlängen, für welche das Substrat nicht opak ist, und den Wellenlängen von Strahlung, für welche die lichtempfindlichen Materialien empfindlich sind, und wobei die Struktur mit aushärtender Strahlung von einer Strahlungsquelle mit einem schmalen Emissionsspektrum belichtet wird.

13. Strukturierte Struktur, hergestellt aus einer fotostrukturierbaren Struktur gemäß einem der Ansprüche 1 bis 4.

14. Strukturierte Struktur gemäß Anspruch 13, die verschiedene Strukturen auf der ersten und zweiten Seite aufweist.

15. Berührungssensibler Bildschirm, insbesondere ein kapazitiver berührungssensibler Bildschirm, umfassend eine strukturierte Struktur gemäß einem der Ansprüche 13 oder 14.

## Revendications

1. Structure réalisable par photo-exposition, comprenant un substrat optiquement transparent ayant des première et seconde faces, un revêtement d'un premier matériau photosensible du substrat sur la première face et un revêtement d'un second matériau photosensible sur la seconde face du substrat, le substrat revêtu étant opaque à un rayonnement électromagnétique d'une ou de plusieurs longueurs d'onde auxquelles les premiers et seconds matériaux photosensibles sont sensibles.

2. Structure selon la revendication 1, dans laquelle les premiers et seconds matériaux photosensibles sont identiques.

3. Structure selon la revendication 1 ou 2, comprenant en outre un revêtement de surface sur l'un des revêtements de matériaux photosensibles ou les deux.

4. Structure selon la revendication 3, dans lequel le revêtement de surface est soluble dans un milieu de développement pouvant être utilisé dans l'élimination du matériau photosensible, après cuisson.

5. Procédé de photo-exposition d'une structure réalisable par photo-exposition selon l'une quelconque des revendications précédentes, comprenant l'exposition des premier et second matériaux photosensibles à un rayonnement de cuisson auxquels les matériaux photosensibles sont sensibles mais auquel le substrat revêtu est opaque.

6. Procédé selon la revendication 5, dans lequel les première et seconde faces de la structure sont exposées simultanément à un rayonnement de cuisson.

7. Procédé selon la revendication 5 ou 6, dans lequel les faces de la structure sont exposées à un rayonnement selon un motif de façon à réaliser la photo-exposition.

8. Procédé selon la revendication 7, dans lequel les motifs sur les deux faces sont différents.

9. Procédé selon l'une quelconque des revendications 5 à 8, dans lequel après la réaction de cuisson, les matériaux photosensibles sont soumis à un processus de développement en utilisant un milieu de développement sélectivement pour supprimer les matériaux photosensibles solubles du substrat, laissant derrière des modèles de matériaux photosensibles insolubles sur les première et seconde faces du substrat.

10. Procédé selon la revendication 9, dans lequel le milieu de développement élimine également tout revêtement de surface sur la structure.

11. Procédé selon l'une quelconque des revendications 5 à 10, ne présentant aucun chevauchement des longueurs d'onde auxquelles le substrat n'est pas opaque et des longueurs d'onde de rayonnement auxquelles les matériaux photosensibles sont sensibles, et la structure est exposée à un rayonnement de cuisson provenant d'une source de rayonnement à large bande.

12. Procédé selon l'une quelconque des revendications 5 à 10, présentant un chevauchement des longueurs d'onde auxquelles le substrat n'est pas opaque et des longueurs d'onde de rayonnement auxquelles les matériaux photosensibles sont sensibles, et la structure est exposée à un rayonnement de cuisson provenant d'une source de rayonnement à spectre d'émission étroit.

13. Structure à motifs produite à partir d'une structure réalisable par photo-exposition selon l'une quelconque des revendications 1 à 4.

14. Structure à motifs selon la revendication 13, ayant des motifs différents sur les première et seconde faces.

15. Ecran tactile, particulièrement un écran tactile capacitif, comprenant une structure à motifs selon la revendication 13 ou 14.
